# EUROPEAN PATENT APPLICATION

(11) **EP 4 749 842 A1**
(43) Date of publication of application: **27.05.2026**
(21) Application number: 24843141.3
(22) Date of filing: 16.07.2024
(51) Int. Cl.: H01S 5/0236, G01S 7/481, G01S 7/484, G01S 17/931, H01S 5/183, H01S 5/02345

(54) **LIGHT SOURCE, MEASUREMENT DEVICE, METHOD FOR MANUFACTURING LIGHT SOURCE, AND METHOD FOR MANUFACTURING MEASUREMENT DEVICE**

(30) Priority: 18.07.2023 JP 2023116439; 18.07.2023 JP 2023116441
(71) Applicant: Koito Manufacturing Co., Ltd., Tokyo 141-0001 (JP)
(72) Inventor: SONE, Hidemichi, Shizuoka-shi, Shizuoka 424-8764 (JP); ITO, Yoshiro, Shizuoka-shi, Shizuoka 424-8764 (JP)
(74) Representative: Cabinet Beau de Loménie
(86) International application number: PCT/JP2024/025538
(87) International publication number: WO 2025/018351

(57) **Abstract**

A light source (122) comprises: a light-emitting chip (1100) in which a surface light-emitting element (1110) is disposed, the light-emitting chip (1100) having a first surface (1102) that is electrically connected to the cathode of the surface light-emitting element (1110), and a second surface (1101) that is electrically connected to the anode of the surface light-emitting element (1110); a substrate (1200) in which a first conductive pattern (1210) and a second conductive pattern (1220) are formed; a conductive joining part (1300) that joins the first surface (1102) of the light-emitting chip (1100) and the first conductive pattern (1210); and a wire (1250) that electrically connects the second surface (1101) of the light-emitting chip (1100) and the second conductive pattern (1220). The light source (122) further comprises a non-conductive protection part (1310) that is disposed on the outer peripheral side of the joining part (1300) and that covers at least a portion of the outer peripheral surface of the joining part (1300).

## Description

### TECHNICAL FIELD

The technology disclosed in the present description relates to a light source, a measurement device, a method for manufacturing a light source, and a method for manufacturing a measurement device.

### BACKGROUND ART

With the progress of autonomous driving (AD) and advanced driver-assistance systems (ADAS), development and research of light detection and ranging (LiDAR) serving as one of measurement devices used for grasping a surrounding environment and self-position estimation during traveling of a vehicle have been advanced. The LiDAR includes a light projector that projects (emits) laser light to a measurement target and a light receiver that receives reflected light obtained by the laser light being reflected by the measurement target and returned. The LiDAR outputs information on the measurement target by measuring a distance to the measurement target based on a difference between a timing at which the light projector emits the laser light and a timing at which the light receiver receives the reflected light. The light projector includes a light source and a projection lens through which light emitted by the light source passes (for example, see Patent Literature 1).

The light projector includes a semiconductor laser that emits laser light. The light receiver includes a filter that transmits laser light in a predetermined passband in the laser light output from the light projector and reflected by the measurement target, and a light receiving element that receives the laser light having passed through the filter (for example, see Patent Literature 1).

### CITATION LIST

### PATENT LITERATURE

Patent Literature 1: JP2021-105613A

### SUMMARY OF INVENTION

### TECHNICAL PROBLEM

The present inventors have studied using a light source including a light emitting chip on which a surface light emitting element is provided as a light source provided in a light projector. The light source includes a light emitting chip, a substrate, a conductive bonding portion, and a wire. The light emitting chip has a first surface electrically connected to a cathode of the surface light emitting element and a second surface electrically connected to an anode of the surface light emitting element. A first conductive pattern and a second conductive pattern are formed on the substrate. The bonding portion bonds the first surface of the light emitting chip and the first conductive pattern. The wire electrically connects the second surface of the light emitting chip and the second conductive pattern.

In such a light source, the cathode of the surface light emitting element may be short-circuited to a conductive member such as the wire or the anode of the surface light emitting element via the bonding portion having conductivity.

The present description discloses a technique capable of solving the problem described above.

In general, a specification sheet of a semiconductor laser shows a specified wavelength band. The specified wavelength band is a variation range assumed in advance for the wavelength of the laser light emitted by the semiconductor laser. The specified wavelength band is specified based on, for example, manufacturing variations of the semiconductor laser. In the measurement device in the related art, it is assumed that the wavelength of the laser light of the semiconductor laser varies within the specified wavelength band, and the passband of the filter provided in the light receiver is set to a band including the specified wavelength band described above.

The actual wavelength band of the laser light emitted by the semiconductor laser mounted on the measurement device is only a part of the specified wavelength band. In short, in the measurement device in the related art, the passband of the filter is set to a bandwidth fairly larger than that of the wavelength band necessary for actual measurement. Therefore, the light receiving element easily receives not only the laser light emitted by the semiconductor laser but also noise (ambient light such as sunlight having a wavelength different from that of the semiconductor laser), and as a result, the measurement accuracy (for example, the measurable distance is shortened) of the measurement device may decrease.

The present description discloses a technique capable of solving the problem described above.

### SOLUTION TO PROBLEM

The technology disclosed in the present description can be achieved in, for example, the following aspects.
(1) A light source according to an aspect disclosed in the present description including: a light emitting chip on which a surface light emitting element is provided, the light emitting chip including a first surface electrically connected to a cathode of the surface light emitting element and a second surface electrically connected to an anode of the surface light emitting element; a substrate on which a first conductive pattern and a second conductive pattern are formed; a bonding portion configured to bond the first surface of the light emitting chip and the first conductive pattern, the bonding portion being conductive; a wire configured to electrically connect the second surface of the light emitting chip and the second conductive pattern, and a protection portion that is provided on an outer peripheral side of the bonding portion and that covers at least a part of an outer peripheral surface of the bonding portion, the protection portion being non-conductive.
   According to the present light source, as compared with a configuration in which the protection portion is not provided on the outer peripheral side of the conductive bonding portion, the cathode of the surface light emitting element can be prevented from being short-circuited to a conductive member such as the anode of the surface light emitting element via the bonding portion.
(2) In the light source according to (1) described above, a connection portion to which the wire is electrically connected may be provided on a peripheral edge portion of the second surface of the light emitting chip, and the protection portion may cover an outer peripheral surface of the bonding portion on a connection portion side. According to the present light source, since the protection portion is interposed between the bonding portion and the wire, it is possible to prevent the cathode of the surface light emitting element from being short-circuited to the wire via the bonding portion.
(3) In the light source according to (1) or (2) described above, the protection portion may cover an entire outer peripheral surface of the bonding portion. According to the present light source, the cathode of the surface light emitting element can be effectively prevented from being short-circuited to the conductive member via the bonding portion.
(4) In the light source according to any one of (1) to (3) described above, at least a part of an outer peripheral surface of the bonding portion may be located inside an outer edge of the light emitting chip as viewed in a direction orthogonal to the light emitting chip, and the protection portion may include a support portion sandwiched between the light emitting chip and the substrate. In the present light source, the support portion of the protection portion is interposed in the gap formed between the light emitting chip and the substrate due to the absence of the bonding portion. Therefore, according to the present light source, for example, damage to the light emitting chip due to application of a load to the light emitting chip can be reduced as compared with a configuration in which the support portion is not interposed.
(5) In the light source according to any one of (1) to (4) described above, the protection portion may be in contact with an outer peripheral surface of the bonding portion, and an area of an exposed surface of the protection portion may be larger than a contact area between the protection portion and the bonding portion. According to the present light source, the protection portion is in contact with the outer peripheral surface of the bonding portion functioning as the conductive path. The area of the exposed surface of the protection portion is larger than the contact area between the protection portion and the bonding portion. Therefore, the heat generated at the bonding portion can be effectively released via the protection portion.
(6) A measurement device may include: a light projector including the light source according to any one of (1) to (5) described above; and a light receiver configured to receive light output from the light projector and reflected by a measurement target. According to this configuration, the cathode of the surface light emitting element can be prevented from being short-circuited to a conductive member such as the anode of the surface light emitting element via the bonding portion.
(7) A method for manufacturing a light source according to an aspect disclosed in the present description, the light source including a light emitting chip on which a surface light emitting element is provided, the light emitting chip including a first surface electrically connected to a cathode of the surface light emitting element and a second surface electrically connected to an anode of the surface light emitting element, and a substrate on which a first conductive pattern and a second conductive pattern are formed, the method including: a step of applying a first bonding material between the first surface of the light emitting chip and the first conductive pattern of the substrate, the first bonding material being conductive, and applying a second bonding material to at least a part of a periphery of the first bonding material, the second bonding material being non-conductive; a step of electrically connecting the second surface of the light emitting chip and the second conductive pattern by a wire; and a step of curing the first bonding material and the second bonding material to form a conductive bonding portion formed between the first surface of the light emitting chip and the substrate, and to form a protection portion configured to cover at least a part of an outer peripheral surface of the bonding portion. According to the present manufacturing method, the light source can be manufactured while preventing the cathode of the surface light emitting element from being short-circuited to a conductive member such as the anode of the surface light emitting element via the bonding portion.
(8) A light source according to another aspect disclosed in the present description including: a light emitting chip on which a surface light emitting element is provided, the light emitting chip including a first surface electrically connected to a cathode of the surface light emitting element and a second surface electrically connected to an anode of the surface light emitting element; a substrate on which a first conductive pattern and a second conductive pattern are formed; a bonding portion configured to bond the first surface of the light emitting chip and the first conductive pattern, the bonding portion being conductive; and a wire configured to electrically connect the second surface of the light emitting chip and the second conductive pattern, in which, as viewed in a first direction orthogonal to the light emitting chip, at least a part of an outer peripheral surface of the bonding portion is located inside an outer edge of the light emitting chip, and in which the connection portion between the wire and the second surface is located inside the outer peripheral surface of the bonding portion. According to the present light source, for example, as compared to a configuration in which the bonding portion between the wire and the light emitting chip is located outside the outer peripheral surface of the bonding portion, it is possible to reduce damage to the light emitting chip due to a load applied to the connection portion of the light emitting chip.
(9) In the light source according to (8) described above, as viewed in the first direction, a peripheral edge of a light emitting region of the light emitting chip may be located inside the outer peripheral surface of the bonding portion, and an inclination angle θ formed by a virtual surface with respect to the first direction may be 45 degrees or more, the virtual surface passing through a ridge line of the light emitting region and a ridge line of the outer peripheral surface of the bonding portion. According to the present light source, heat generated in the light emitting region can be effectively released to the outside by the bonding portion.
(10) A measurement device according to an aspect disclosed in the present description including: a light projector including a semiconductor laser configured to emit laser light; and a light receiver including a filter configured to transmit laser light in a specific passband in the laser light output from the light projector and reflected by a measurement target, and a light receiving element configured to receive the laser light that is passed through the filter, in which the specific passband of the filter is a part of a specified wavelength band specified based on a manufacturing variation of the semiconductor laser. According to the present measurement device, as compared with a configuration in which the specific passband of the filter is the same as the specified wavelength band, the influence of noise such as sunlight is reduced, and for example, the measurable distance can be improved.
(11) In the measurement device according to (10) described above, the semiconductor laser may include a first semiconductor laser and a second semiconductor laser, the filter may include a first filter configured to transmit laser light emitted from the first semiconductor laser and a second filter configured to transmit laser light emitted from the second semiconductor laser, the first semiconductor laser and the second semiconductor laser may have the same specified wavelength band, and the first filter and the second filter may have different specific passbands. According to the present measurement device, in the measurement based on the laser light of each of the first semiconductor laser and the second semiconductor, the influence of noise is reduced, and for example, the measurable distance can be improved.
(12) In the measurement device according to (10) or (11) described above, a bandwidth of the specific passband may be 1/2 or less of a bandwidth of the specified wavelength band. According to the present measurement device, it is possible to more effectively reduce the influence of noise.
(13) A method for manufacturing a measurement device according to an aspect disclosed in the present description, the measurement device including a light projector including a semiconductor laser configured to emit laser light, and a light receiver including a filter configured to transmit laser light in a specific passband in the laser light output from the light projector and reflected by a measurement target, and a light receiving element configured to receive the laser light that has passed through the filter, the method including: a step of determining which of a plurality of wavelength classes a selected semiconductor laser selected from a plurality of semiconductor lasers belongs to, the plurality of wavelength classes being specified by dividing a specified wavelength band specified based on a manufacturing variation of the semiconductor laser; and a step of providing, in the light receiver, the filter having a specific passband corresponding to a wavelength class to which the selected semiconductor laser belongs. According to the present manufacturing method, the measurement device in which the influence of noise is more effectively reduced can be efficiently manufactured.

The technology disclosed in the present description can be achieved in various forms, and can be achieved in forms such as a light source, a measurement device including the light source, a method for manufacturing a light source, a method for selecting a filter, and a method for manufacturing a measurement device.

### BRIEF DESCRIPTION OF DRAWINGS

[FIG. 1] FIG. 1 is a block diagram schematically illustrating a configuration of a measurement device 110 according to a first embodiment.
[FIG. 2] FIG. 2 is a diagram illustrating an upper configuration of a light source 122.
[FIG. 3] FIG. 3 is a diagram illustrating a cross-sectional configuration of the light source 122 at a position of III-III in FIG. 2.
[FIG. 4] FIG. 4 is a flowchart illustrating a part of a manufacturing step of the light source 122.
[FIG. 5] FIG. 5 is a diagram illustrating an upper configuration of a light source 122a according to a second embodiment.
[FIG. 6] FIG. 6 is a diagram illustrating a cross-sectional configuration of the light source 122 at a position of VI-VI in FIG. 5.
[FIG. 7] FIG. 7 is a block diagram schematically illustrating a configuration of a measurement device 210 according to the embodiment.
[FIG. 8] FIG. 8 is a diagram illustrating a specified wavelength band B of a semiconductor laser 223.
[FIG. 9] FIG. 9 is a flowchart illustrating a part of a manufacturing step of the measurement device 210.
[FIG. 10] FIG. 10 is a diagram illustrating classification of the specified wavelength band B.
[FIG. 11] FIG. 11 is a diagram illustrating a specific passband H1 for a first wavelength class f1.
[FIG. 12] FIG. 12 is a diagram illustrating a specific passband H2 for a second wavelength class f2.

### DESCRIPTION OF EMBODIMENTS

### A. First Embodiment:

### A-1. Configuration of Measurement Device 110:

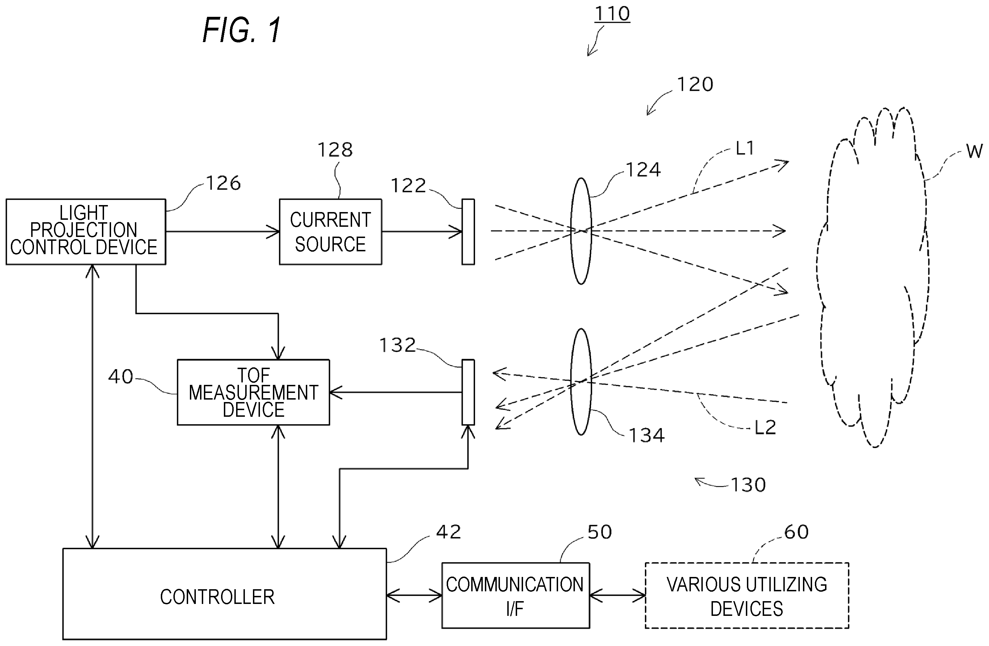

FIG. 1 is a block diagram schematically illustrating a configuration of a measurement device 110 according to a first embodiment. As illustrated in FIG. 1, the measurement device 110 includes a light projector 120 configured to irradiate a measurement target W with emission light L1 (for example, a light beam (laser light)), and a light receiver 130 configured to receive reflected light L2 (return light) obtained by the emission light L1 being reflected by the measurement target W and returned, and functions as a flash LiDAR. The measurement device 110 is configured to measure a difference (time of flight of the laser light, hereinafter referred to as time of flight ("TOF")) between a timing at which the light projector 120 emits the emission light L1 and a timing at which the light receiver 130 receives the reflected light L2 to acquire information on the measurement target W.

The measurement device 110 is mounted on, for example, a vehicle (not illustrated) on which an AD or an ADAS is mounted. For example, the measurement device 110 assists detection of an object such as a person or another vehicle during traveling of the vehicle, and provides other devices or users with various types of information useful for ensuring safety of a driver of the vehicle or a person present around the vehicle and reducing damage to the object present around the vehicle during driving of the vehicle.

The light projector 120 includes a light source 122, a light projection optical system 124, a light projection control device 126, and a current source 128.

The light source 122 includes a light emitting source including one or a plurality of light emitting elements (not illustrated) or a light emitting source including one or a plurality of light emitting element arrays (for example, light emitting elements arranged in a linear (one-dimensional) shape or a planar (two-dimensional) shape). As will be described later, in the present embodiment, the light emitting element is a surface light emitting element 1110. The configuration of the light source 122 will be described later.

The current source 128 is configured to supply to, the light emitting element constituting the light source 122, a current corresponding to a control signal received from the light projection control device 126. The current source 128 is configured to supply, for example, a periodic square-wave current for turning on and off the current flowing through the light emitting element to the light emitting element.

The light projection control device 126 is configured to generate a control signal for controlling the current source 128 and inputs the control signal to the current source 128, thereby controlling a current (a driving current) supplied from the current source 128 to the light emitting element. The light projection control device 126 inputs a signal indicating the timing (hereinafter referred to as "light projection timing") at which the light emitting element emits light to a TOF measurement device 40. For example, the light projection control device 126 is configured to cause the light emitting element to periodically and repeatedly emit light by executing control to periodically and repeatedly turn on and off the current flowing through the light emitting element.

For example, the light projection optical system 124 is configured to adjust the light distribution of the emission light L1 by giving an optical action (refraction, scattering, diffraction, or the like) to the light emitted by the light source 122. The light projection optical system 124 includes, for example, various lenses such as a collimator lens and optical components such as a reflecting mirror (a mirror).

The light receiver 130 includes a light receiving unit 132 and a light receiving optical system 134.

The light receiving optical system 134 is configured to condense, on the light receiving unit 132, the reflected light L2 that is obtained by the emission light L1 from the light projector 120 being reflected by the measurement target W or the like and returned. The light receiving optical system 134 includes, for example, various lenses such as a condenser lens, various filters such as a wavelength filter, and optical components such as a reflecting mirror (a mirror).

The light receiving unit 132 is a light receiving source including one or a plurality of light receiving elements (not illustrated) or one or a plurality of light receiving element arrays (for example, light receiving elements arranged in a linear (one-dimensional) shape or a planar (two-dimensional) shape). The light receiving element is, for example, a photodiode, a single photon avalanche diode (SPAD), or a balanced photodetector. The light receiving unit 132 is configured to photoelectrically convert the reflected light L2 incident from the light receiving optical system 134 to generate a current (hereinafter referred to as a "light receiving current") corresponding to the intensity of the reflected light L2. The light receiving unit 132 is configured to input, to the TOF measurement device 40, a signal indicating a timing (hereinafter, referred to as a "light receiving timing") at which the light receiving element constituting the light receiving unit 132 receives the reflected light L2 and a light receiving current generated by the light receiving element.

The measurement device 110 further includes the TOF measurement device 40, a controller 42, and a communication interface (I/F) 50.

The TOF measurement device 40 is configured to obtain the TOF based on the signal indicating the light projection timing received from the light projection control device 126 and the signal indicating the light receiving timing received from the light receiving unit 132. The TOF measurement device 40 includes, for example, a time measurement integrated circuit (IC) including a time to digital converter (TDC) circuit. The TOF measurement device 40 is configured to input, to the controller 42, the obtained TOF and the light receiving current received from the light receiving unit 132.

The controller 42 includes a processor (a central processing unit (CPU), a micro processing unit (MPU), an application specific integrated circuit (ASIC), a field programmable gate array (FPGA), a digital signal processor (DSP), and the like). The controller 42 is configured to generate information used for various measurements such as detection of the measurement target W and distance measurement based on the light receiving current and the TOF that are received from the TOF measurement device 40. Examples of the information include a histogram used in a time correlated signal photon counting method, a distance to each point of the measurement target W, and a point cloud. The controller 42 is configured to control the light projection control device 126 and the light receiving unit 132. The controller 42 is configured to control, for example, the light projection control device 126 and the light receiving unit 132 to control the light projection timing and the light receiving timing described above such that the processing related to the generation of the histogram is accelerated or optimized. The information generated by the controller 42 is provided (transmitted) to devices (hereinafter referred to as "various utilizing devices 60") that utilize the information via the communication I/F 50.

The various utilizing devices 60 is configured to execute, for example, the creation of environmental maps using the point cloud, self-position estimation (simultaneous localization and mapping (SLAM)) using scan matching algorithms (normal distributions transform (NDT), iterative closest point (ICP), and the like).

### A-2. Configuration of Light Source 122:

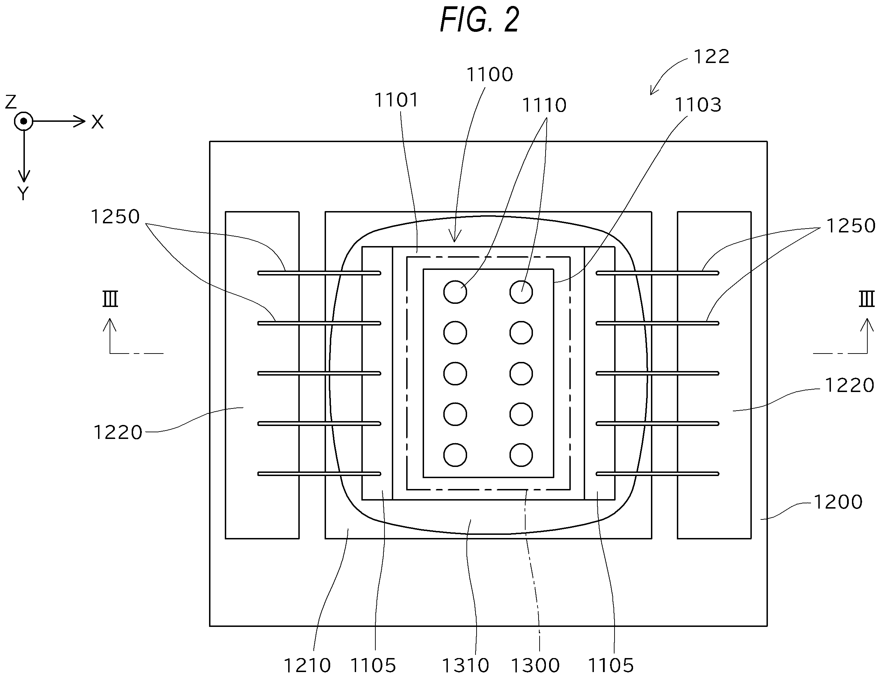

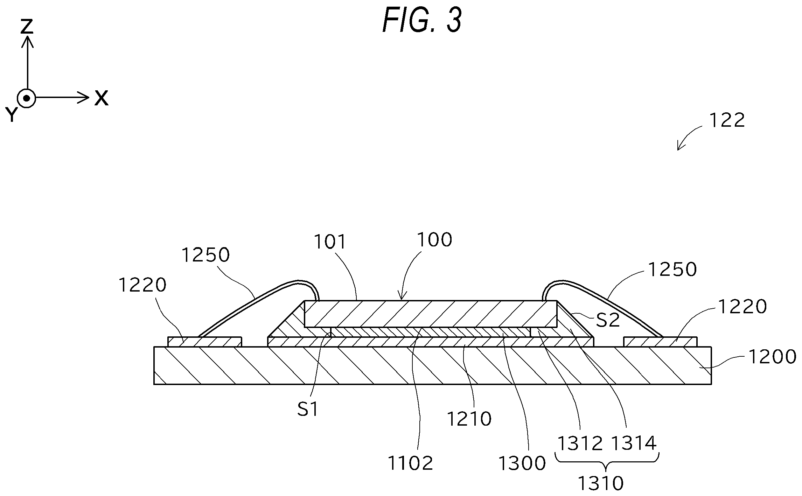

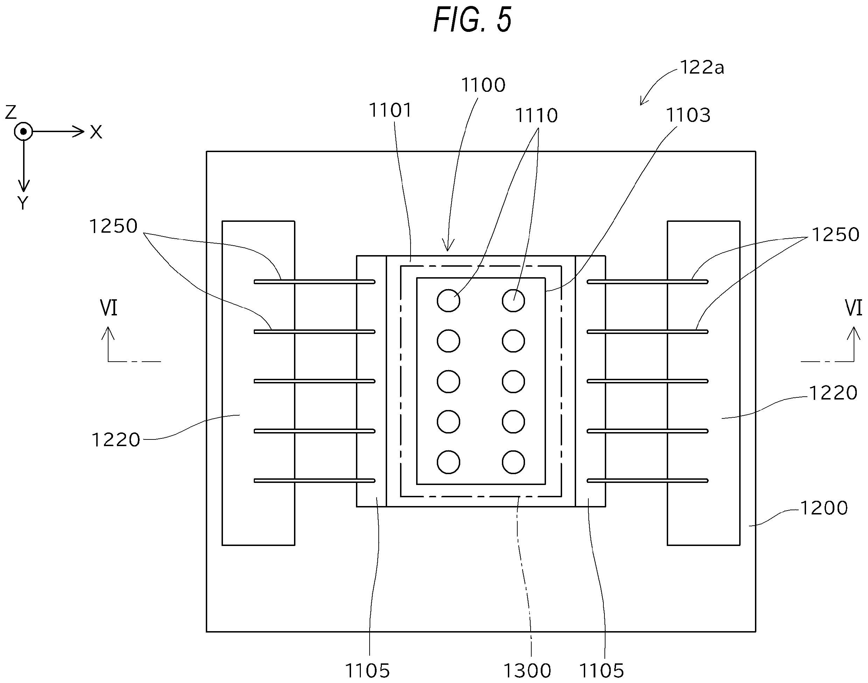

FIG. 2 is a diagram illustrating an upper configuration of the light source 122, and FIG. 3 is a diagram illustrating a cross-sectional configuration of the light source 122 at a position of III-III in FIG. 2. In FIGS. 2 and 3, XYZ axes orthogonal to one another for specifying directions are illustrated. In the present description, for convenience, a Z-axis positive direction is referred to as an upper direction, a Z-axis negative direction is referred to as a lower direction, an X-axis positive direction is referred to as a right direction, an X-axis negative direction is referred to as a left direction, a Y-axis positive direction is referred to as a front direction, and a Y-axis negative direction is referred to as a rear direction. The same applies to FIG. 5 and subsequent drawings to be described later.

As illustrated in FIGS. 2 and 3, the light source 122 includes a light emitting chip 1100, a substrate 1200, a bonding portion 1300 that is conductive , and a wire 1250.

The light emitting chip 1100 is a surface light emitting element array in which a plurality of surface light emitting elements 1110 are two-dimensionally arranged on a substrate (a semiconductor substrate, a ceramic substrate, or the like). The surface light emitting element 1110 is a surface light emitting type laser light emitting element, and is, for example, a vertical cavity surface emitting laser (VCSEL). That is, the light emitting chip 1100 is a VCSEL array in which a plurality of VCSELs are arranged. By using the surface light emitting element array as the light source of the light projector 120, it is possible to implement the light projector 120 capable of performing highly reliable high-speed beam scanning in a space-saving manner.

An upper surface 1101 of the light emitting chip 1100 includes a light emitting region 1103 and a pair of connection regions 1105. The upper surface 1101 is an example of a second surface. The light emitting region 1103 is a region where a plurality of surface light emitting elements 1110 are arranged, and is a region where the plurality of surface light emitting elements 1110 emit light. The light emitting region 1103 is located at the central portion of the upper surface 1101 in the left-right direction. The pair of connection regions 1105 are formed at both end portions of the upper surface 1101 in the left-right direction. The connection regions 1105 are electrically connected to the anodes of the plurality of surface light emitting elements 1110. A lower surface 1102 of the light emitting chip 1100 is electrically connected to the cathodes of the plurality of surface light emitting elements 1110. The lower surface 1102 is an example of a first surface.

A first conductive pattern 1210 and a pair of second conductive patterns 1220 are formed on the substrate 1200. The first conductive pattern 1210 is formed at the central portion of the substrate 1200 in the left-right direction. The pair of second conductive patterns 1220 are formed at both end portions of the substrate 1200 in the left-right direction.

The bonding portion 1300 is a bonding portion that is conductive, and is made of a conductive material. The conductive material may be, for example, a metal (sintered silver, gold-tin (Au-Sn) solder, tin-silver-copper (Sn-Ag-Cu) solder, or the like), or may be a resin containing a metal (for example, silver) filler.

The bonding portion 1300 bonds the light emitting chip 1100 and the first conductive pattern 1210 of the substrate 1200, and electrically connects the lower surface 1102 of the light emitting chip 1100 and the first conductive pattern 1210. Specifically, the upper surface of the bonding portion 1300 is bonded to the lower surface 1102 of the light emitting chip 1100 in a surface contact state. The lower surface of the bonding portion 1300 is bonded to the upper surface of the first conductive pattern 1210 in a surface contact state. Thus, the cathodes of the plurality of surface light emitting elements 1110 are electrically connected to the first conductive pattern 1210 via the bonding portion 1300.

The wire 1250 electrically connects the connection region 1105 of the light emitting chip 1100 and the second conductive pattern 1220 on the substrate 1200. One end portion of the wire 1250 is bonded to the connection region 1105 of the light emitting chip 1100, and the other end portion of the wire 1250 is bonded to the second conductive pattern 1220. In the present embodiment, the left connection region 1105 and the left second conductive pattern 1220 are electrically connected to each other by a plurality of wires 1250 arranged at intervals in the front-rear direction. The right connection region 1105 and the right second conductive pattern 1220 are electrically connected to each other by a plurality of wires 1250 arranged at intervals in the front-rear direction. The wire 1250 is made of, for example, gold.

### A-3. Configuration for Preventing Short-Circuit Between Cathode of Surface Light Emitting Element 1110 and Conductive Member:

In the present embodiment, the light source 122 has a configuration for preventing the cathode of the surface light emitting element 1110 from being short-circuited to the conductive member via the bonding portion 1300. The conductive member is, for example, another conductive member located around the wire 1250, the second conductive pattern 1220, and the light emitting chip 1100.

Specifically, the light source 122 includes a protection portion 1310. The protection portion 1310 is a non-conductive bonding portion and is made of a non-conductive material. The non-conductive material is, for example, a resin. The non-conductive material may be a mixed material in which a filler formed of a material (for example, a ceramic material such as aluminum oxide (Al₂O₃) or aluminum nitride (AlN)) having higher thermal conductivity than the resin is mixed with the resin in order to improve heat dissipation.

The protection portion 1310 covers an entire outer peripheral surface S1 of the bonding portion 1300. That is, the outer peripheral surface S1 of the bonding portion 1300 is not exposed to the outside over the entire circumference.

The protection portion 1310 includes a support portion 1312 and a protruding portion 1314.

The support portion 1312 is a portion of the protection portion 1310 sandwiched between the light emitting chip 1100 and the first conductive pattern 1210 (the substrate 1200). Specifically, in the present embodiment, as viewed in the upper-lower direction, the outline of the bonding portion 1300 is located inside the outline of the light emitting chip 1100 over the entire circumference (see FIG. 2). Therefore, the peripheral edge portion of the lower surface 1102 of the light emitting chip 1100 is separated from the first conductive pattern 1210 in the upper-lower direction. The support portion 1312 of the protection portion 1310 is provided in a gap between the peripheral edge portion of the lower surface 1102 of the light emitting chip 1100 and the first conductive pattern 1210. The upper surface of the support portion 1312 is in contact with the peripheral edge portion of the lower surface 1102 of the light emitting chip 1100, and the lower surface of the support portion 1312 is in contact with the first conductive pattern 1210. In this way, the support portion 1312 supports the peripheral edge portion of the lower surface 1102 of the light emitting chip 1100. The support portion 1312 is provided over the entire circumference of the bonding portion 1300. The support portion 1312 is in contact with the outer peripheral surface S1 of the bonding portion 1300 over the entire circumference. The view in the upper-lower direction is an example of a view in a direction orthogonal to the light emitting chip 1100. The direction orthogonal to the light emitting chip 1100 is a direction orthogonal to the light emitting surface of the light emitting chip 1100.

The protruding portion 1314 is a portion of the protection portion 1310 that protrudes outward beyond the light emitting chip 1100 as viewed in the upper-lower direction. The area of an exposed surface S2 of the protruding portion 1314 is larger than the contact area (the area of the outer peripheral surface S1) between the protection portion 1310 (the support portion 1312) and the bonding portion 1300. Specifically, the protruding portion 1314 covers the entire outer peripheral surface S1 of the light emitting chip 1100. Therefore, the peripheral edge portion of the light emitting chip 1100 is protected by the protruding portion 1314. The exposed surface S2 of the protruding portion 1314 is a tapered surface inclined so as to spread to the outer peripheral side as approaching the substrate 1200. In this way, since the exposed surface S2 of the protruding portion 1314 is widely secured, heat dissipation by the protection portion 1310 is high.

### A-4. Method for Manufacturing Light Source 122:

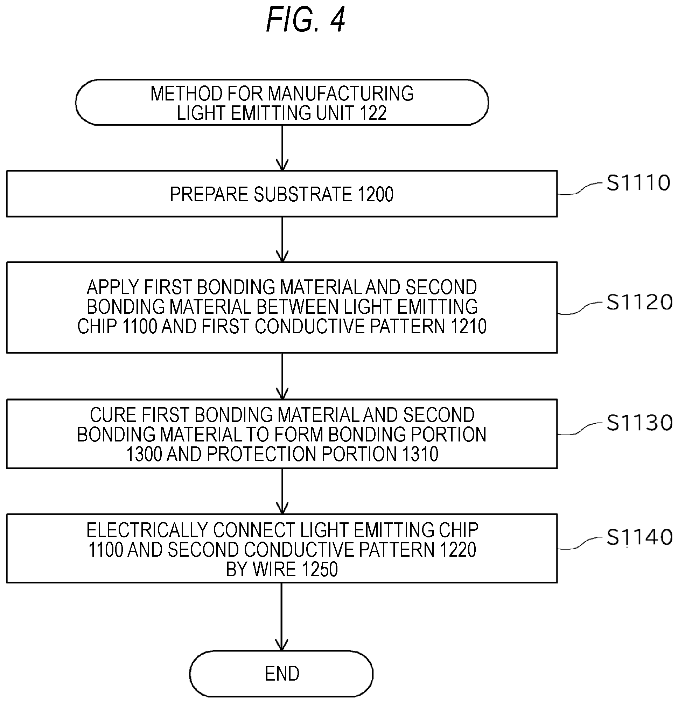

FIG. 4 is a flowchart illustrating a part of a manufacturing step of the light source 122. As illustrated in FIG. 4, the substrate 1200 is prepared on which the first conductive pattern 1210 and the second conductive pattern 1220 are formed (S1110).

Next, a first bonding material is applied between the lower surface 1102 of the light emitting chip 1100 and the first conductive pattern 1210 of the substrate 1200, and a second bonding material is applied around the first bonding material (S1120). The first bonding material is formed of a conductive bonding material (for example, an adhesive resin paste containing a conductive material, or solder), and forms the bonding portion 1300 described above when cured. The second bonding material is formed of a non-conductive bonding material (for example, an adhesive resin paste containing no conductive material), and forms the protection portion 1310 described above when cured.

For example, the light emitting chip 1100 and the first conductive pattern 1210 may be soldered by the first bonding material which is solder, and then the second bonding material may be applied around the first bonding material. Alternatively, the adhesive first bonding material and the adhesive second bonding material may be applied onto the first conductive pattern 1210, and then the light emitting chip 1100 may be provided on the first bonding material and the second bonding material. The first bonding material and the second bonding material may be applied to the first conductive pattern 1210 in any order. By providing the second bonding material around the first bonding material, it is possible to prevent the first bonding material from protruding outside the light emitting chip 1100 or creeping up to the outer peripheral surface side of the light emitting chip 1100.

Next, the first bonding material and the second bonding material are cured to form the conductive bonding portion 1300 formed between the lower surface 1102 of the light emitting chip 1100 and the substrate 1200 (the first conductive pattern 1210), and the protection portion 1310 covering the outer peripheral surface S1 of the bonding portion 1300 (S 1130).

Next, the upper surface 1101 (the connection region 1105) of the light emitting chip 1100 and the second conductive pattern 1220 are electrically connected by the wire 1250 (S1140). Here, if the non-conductive second bonding material (the protection portion 1310 when cured) is not present around the conductive first bonding material (the bonding portion 1300 when cured), the wire 1250 may come into contact with the first bonding material and be short-circuited when the wire 1250 is connected. However, in the present embodiment, the second bonding material is provided around the first bonding material, and the connection region 1105 side of the outer peripheral surface S1 of the first bonding material is not exposed to the outside. Therefore, it is possible to prevent a short circuit between the wire 1250 and the first bonding material when the wire 1250 is connected. At least one of the first bonding material and the second bonding material may be cured before the step S1140 described above, after the step S1140, or during the step S1140. Thereafter, predetermined post-processing is performed to complete the manufacturing of the light source 122.

### A-5. Advantageous Effects of Present Embodiment:

As described above, in the light source 122 according to the present embodiment, the non-conductive protection portion 1310 covers the outer peripheral surface S1 of the conductive bonding portion 1300 (see FIGS. 2 and 3). Therefore, as compared with a configuration in which the protection portion 1310 is not provided on the outer peripheral side of the bonding portion 1300, the cathode of the surface light emitting element 1110 can be prevented from being short-circuited to a conductive member such as the anode of the surface light emitting element 1110 via the bonding portion 1300. Moreover, in the present embodiment, the protection portion 1310 covers the entire outer peripheral surface S1 of the bonding portion 1300. Therefore, the cathode of the surface light emitting element 1110 can be effectively prevented from being short-circuited to the conductive member via the bonding portion 1300.

In the light source 122 illustrated in FIG. 3, if the support portion 1312 is not present, the peripheral edge portion of the lower surface 1102 of the light emitting chip 1100 floats in the air from the substrate 1200. As a result, when a load is applied to the peripheral edge portion of the light emitting chip 1100, the light emitting chip 1100 is likely to be damaged. On the other hand, in the present embodiment, the protection portion 1310 includes the support portion 1312 sandwiched between the light emitting chip 1100 and the first conductive pattern 1210 (the substrate 1200). Accordingly, according to the present embodiment, for example, damage to the light emitting chip 1100 due to application of a load to the light emitting chip 1100 can be reduced as compared with a configuration in which the support portion 1312 is not present.

In the present embodiment, the protection portion 1310 is in contact with the outer peripheral surface S1 of the bonding portion 1300 that functions as a conductive path. The area of the exposed surface S2 of the protruding portion 1314 is larger than the contact area (the area of the outer peripheral surface S1) between the bonding portion 1300 and the support portion 1312. Accordingly, according to the present embodiment, the heat generated in the bonding portion 1300 can be effectively released via the protection portion 1310.

### B. Second Embodiment:

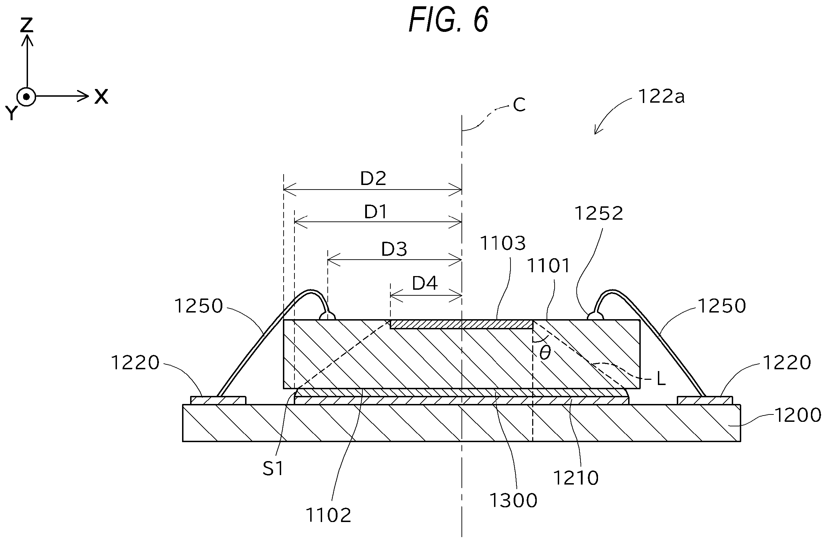

FIG. 5 is a diagram illustrating an upper configuration of a light source 122a in a second embodiment, and FIG. 6 is a diagram illustrating a cross-sectional configuration of the light source 122 at a position of VI-VI in FIG. 5. Hereinafter, in the configuration of the measurement device 110 according to the second embodiment, the description of the same configuration as that of the measurement device 110 according to the first embodiment described above will be appropriately omitted.

### B-1. Configuration for Preventing Short-Circuit Between Cathode of Surface Light Emitting Element 1110 and Conductive Member:

In the second embodiment, the light source 122a has a configuration different from that of the light source 122 according to the first embodiment described above. Specifically, the light source 122a is different from the light source 122 in that the protection portion 1310 is not provided. However, in the second embodiment, the light source 122a also has a configuration for preventing the cathode of the surface light emitting element 1110 from being short-circuited to the conductive member via the bonding portion 1300.

The light source 122a further satisfies the following first condition.

### <First Condition>

As viewed in the upper-lower direction, the outer peripheral surface S1 of the bonding portion 1300 is located inside the outer edge of the light emitting chip 1100 (see FIG. 5), and a connection portion 1252 between the wire 1250 and the upper surface 1101 (the connection region 1105) of the light emitting chip 1100 is located inside the outer peripheral surface S1 of the bonding portion 1300.

Specifically, as illustrated in FIG. 6, a first distance D1 from a central axis C of the light emitting chip 1100 to the outer peripheral surface S1 of the bonding portion 1300 is smaller than a second distance D2 from the central axis C to the outer peripheral surface of the light emitting chip 1100. A third distance D3 from the central axis C to the connection portion 1252 is smaller than the first distance D1.

The light source 22a further satisfies the following second condition.

### <Second Condition>

As viewed in the upper-lower direction, the peripheral edge of the light emitting region 1103 of the light emitting chip 1100 is located inside the outer peripheral surface S1 of the bonding portion 1300, and an inclination angle θ formed by a virtual surface L passing through the ridge line of the light emitting region 1103 and the ridge line of the outer peripheral surface S1 of the bonding portion 1300 with respect to the upper-lower direction is 45 degrees or more.

Specifically, as illustrated in FIG. 6, a fourth distance D4 from the central axis C to the peripheral edge of the light emitting region 1103 is smaller than the first distance D1. The inclination angle θ of the virtual surface L described above with respect to the central axis C is 45 degrees or more.

### B-2. Advantageous Effects of Present Embodiment:

As described above, in the light source 122a according to the present embodiment, the outer peripheral surface S1 of the bonding portion 1300 is located inside the outer edge of the light emitting chip 1100 as viewed in the upper-lower direction (see FIG. 5, the first condition). Therefore, for example, as compared with a configuration in which the bonding portion 1300 protrudes to the outside of the light emitting chip 1100, it is possible to prevent the cathode of the surface light emitting element 1110 from being short-circuited to the conductive member via the bonding portion 1300. Moreover, in the present embodiment, the outer edge of the first conductive pattern 1210 is also located inside the outer edge of the light emitting chip 1100 as viewed in the upper-lower direction (see FIG. 6).

In the present embodiment, the connection portion 1252 between the wire 1250 and the upper surface 1101 of the light emitting chip 1100 is located inside the outer peripheral surface S1 of the bonding portion 1300 (the first condition). According to the present embodiment, for example, as compared to a configuration in which the connection portion 1252 is located outside the outer peripheral surface S1 of the bonding portion 1300, it is possible to reduce damage to the light emitting chip 1100 due to a load applied to the connection portion 1252 of the light emitting chip 1100.

In the present embodiment, the peripheral edge of the light emitting region 1103 of the light emitting chip 1100 is located inside the outer peripheral surface S1 of the bonding portion 1300, and the inclination angle θ formed by the virtual surface L passing through the ridge line of the light emitting region 1103 and the ridge line of the outer peripheral surface S1 of the bonding portion 1300 with respect to the upper-lower direction is 45 degrees or more (the second condition). The radiation angle at which the heat generated in the light emitting region 1103 diffuses toward the lower surface 1102 of the light emitting chip 1100 is 45 degrees or less with respect to the central axis C. Therefore, according to the present embodiment, for example, as compared to a configuration in which the inclination angle θ is less than 45 degrees, the heat generated in the light emitting region 1103 can be effectively released to the outside by the bonding portion 1300.

### C. Modifications:

The technology disclosed in the present description is not limited to the embodiments described above, and can be modified into various forms without departing from the gist thereof, and for example, the following modifications are also possible.

The configurations of the measurement device 110 and the light sources 122 and 122a in the embodiments described above are merely examples and can be variously modified. For example, in the embodiments described above, the light sources 122 and 122a in which the plurality of surface light emitting elements 1110 are provided are exemplified as the light source. Alternatively, the light source may have a configuration in which one surface light emitting element is provided.

In the embodiments described above, the pair of connection regions 1105 provided on the left and right sides are provided on the upper surface 1101 of the light emitting chip 1100. Alternatively, the connection region 1105 may be provided on only one of the left and right sides. In the embodiments described above, the pair of second conductive patterns 1220 are formed on the substrate 1200. Alternatively, one of the pair of second conductive patterns 1220 may be provided alone. In the embodiments described above, the connection region 1105 and the second conductive pattern 1220 are electrically connected by the plurality of wires 1250. Alternatively, the connection region 1105 and the second conductive pattern 1220 may be electrically connected by one wire 1250.

In the first embodiment described above, the protection portion 1310 has a bonding function of bonding the light emitting chip 1100 and the substrate 1200 (the first conductive pattern 1210), and may not have the bonding function. For example, the protection portion 1310 may be fixedly provided on the substrate 1200 and may not be bonded to the light emitting chip 1100. In this configuration, the protection portion 1310 is preferably in contact with the light emitting chip 1100, and may not be in contact with the light emitting chip 1100 and may cover only the lower portion of the outer peripheral surface S1 of the bonding portion 1300. If the protection portion 1310 covers even a part of the outer peripheral surface S1 of the bonding portion 1300, the cathode of the surface light emitting element 1110 can be prevented from being short-circuited to a conductive member such as the wire 1250 via the bonding portion 1300.

In the first embodiment described above, the protection portion 1310 covers the entire outer peripheral surface S1 of the bonding portion 1300. Alternatively, the protection portion 1310 may cover at least a part of the outer peripheral surface S1 of the bonding portion 1300. For example, the protection portion 1310 may cover only the connection region 1105 side of the outer peripheral surface S1 of the bonding portion 1300. Accordingly, the cathode of the surface light emitting element 1110 can be effectively prevented from being short-circuited to the wire 1250 via the bonding portion 1300.

In the first embodiment described above, at least a part of the outline of the bonding portion 1300 may be located outside the outline of the light emitting chip 1100 as viewed in the upper-lower direction. In the first embodiment described above, the protection portion 1310 may not include any one of the support portion 1312 and the protruding portion 1314. At least one of the support portion 1312 and the protruding portion 1314 may be provided only in a part of the periphery of the bonding portion 1300.

In the first embodiment described above, the protection portion 1310 may not be in contact with the bonding portion 1300. However, in a configuration in which the protection portion 1310 is in contact with the bonding portion 1300, it is possible to improve heat dissipation in which heat generated in the bonding portion 1300 by energization is released to the outside via the protection portion 1310. In the first embodiment described above, the area of the exposed surface S2 of the protruding portion 1314 may be equal to or less than the contact area between the bonding portion 1300 and the protection portion 1310. The exposed surface S2 of the protruding portion 1314 is not limited to a tapered surface, and may be a flat surface along the upper-lower direction or a curved surface.

In the second embodiment described above, one of the first condition and the second condition described above may not be satisfied. As viewed in the upper-lower direction, the outer edge of the first conductive pattern 1210 may be located outside the outer edge of the light emitting chip 1100.

In the embodiments described above, the formation material of the members is merely an example, and the members may be formed of another material.

### D. Third Embodiment:

Hereinafter, a third embodiment of the present disclosure will be described with reference to the drawings. The description of members having the same reference signs as the members already described in the description of the first embodiment will be omitted as appropriate.

### D-1. Configuration of Measurement Device 210:

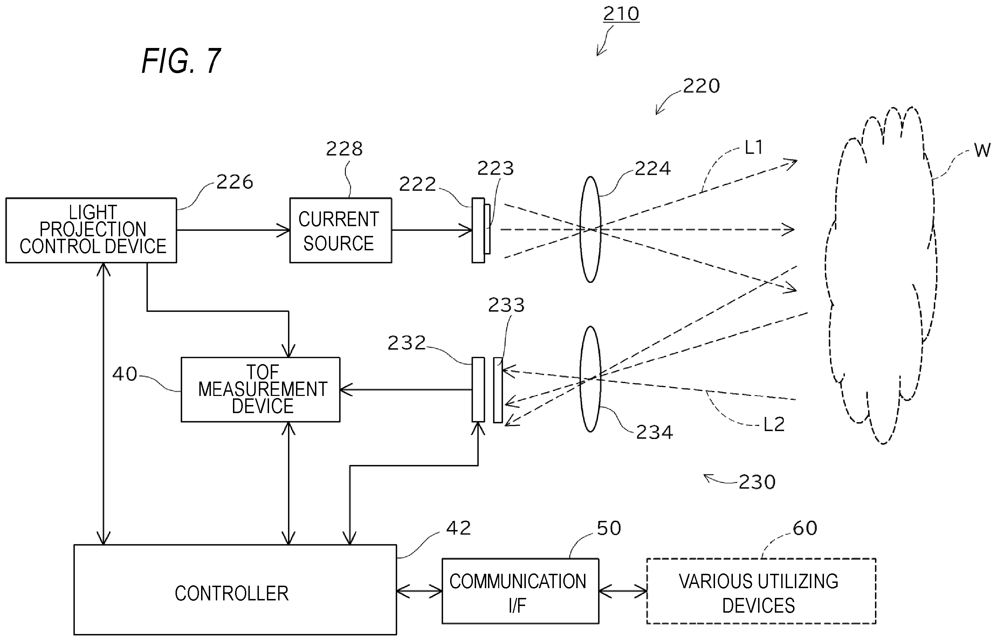

FIG. 7 is a block diagram schematically illustrating a configuration of a measurement device 210 according to the present embodiment. As illustrated in FIG. 7, the measurement device 210 includes a light projector 220 configured to irradiate the measurement target W with the emission light L1 (for example, a light beam (laser light)), and a light receiver 230 configured to receive the reflected light L2 (the return light) obtained by the emission light L1 being reflected by the measurement target W and returned, and functions as a flash LiDAR. The measurement device 210 is configured to measure a difference (time of flight of the laser light, hereinafter referred to as time of flight ("TOF")) between a timing at which the light projector 220 emits the emission light L1 and a timing at which the light receiver 230 receives the reflected light L2 to acquire information on the measurement target W.

The measurement device 210 is mounted on, for example, a vehicle (not illustrated) on which an AD or an ADAS is mounted. For example, the measurement device 210 assists detection of an object such as a person or another vehicle during traveling of the vehicle, and provides other devices or users with various types of information useful for ensuring safety of a driver of the vehicle or a person present around the vehicle and reducing damage to the object present around the vehicle during driving of the vehicle.

The light projector 220 includes a light source 222, a light projection optical system 224, a light projection control device 226, and a current source 228.

The light source 222 includes a light emitting source including one or a plurality of semiconductor lasers (not illustrated) or one or a plurality of semiconductor laser arrays (for example, semiconductor lasers arranged in a linear (one-dimensional) shape or a planar (two-dimensional) shape). The semiconductor laser is, for example, an external cavity vertical surface emitting laser or a laser diode. In the present embodiment, the light source 222 includes one semiconductor laser 223.

The current source 228 is configured to supply a current corresponding to a control signal received from the light projection control device 226 to the semiconductor laser 223 constituting the light source 222. The current source 228 is configured to supply the semiconductor laser 223 with, for example, a periodic square-wave current for turning on and off the current flowing through the semiconductor laser 223.

The light projection control device 226 is configured to generate a control signal for controlling the current source 228 and inputs the control signal to the current source 228, thereby controlling a current (a driving current) supplied from the current source 228 to the semiconductor laser 223. The light projection control device 226 is configured to input a signal indicating the light projection timing at which the semiconductor laser 223 emits light to the TOF measurement device 40. For example, the light projection control device 226 is configured to cause the semiconductor laser 223 to periodically and repeatedly emit light by executing control to periodically and repeatedly turn on and off the current flowing through the semiconductor laser 223.

For example, the light projection optical system 224 is configured to adjust light distribution of the emission light L1 by applying an optical action (refraction, scattering, diffraction, or the like) to the light emitted by the light source 222. The light projection optical system 224 includes, for example, various lenses such as a collimator lens and optical components such as a reflecting mirror (a mirror).

The light receiver 230 includes a light receiving unit 232, a filter 233, and a light receiving optical system 234.

The light receiving optical system 234 is configured to condense, on the light receiving unit 232, the reflected light L2 that is obtained by the emission light L1 from the light projector 220 being reflected by the measurement target W or the like and returned. The light receiving optical system 234 includes, for example, various lenses such as a condenser lens and optical components such as a reflecting mirror (a mirror).

The light receiving unit 232 is a light receiving source including one or a plurality of light receiving elements (not illustrated) or one or a plurality of light receiving element arrays (for example, light receiving elements arranged in a linear (one-dimensional) shape or a planar (two-dimensional) shape). The light receiving element is, for example, a photodiode, a single photon avalanche diode (SPAD), or a balanced photodetector. The light receiving unit 232 is configured to photoelectrically convert the reflected light L2 incident from the light receiving optical system 234 to generate a current (hereinafter referred to as a "light receiving current") corresponding to the intensity of the reflected light L2. The light receiving unit 232 is configured to input a signal indicating a timing (hereinafter, referred to as a "light receiving timing") at which the light receiving element constituting the light receiving unit 232 receives the reflected light L2 and a light receiving current generated by the light receiving element to the TOF measurement device 40.

The filter 233 is a wavelength filter that transmits laser light in a specific passband, and is, for example, a bandpass filter. The specific passband of the filter 233 will be described later. The filter 233 is provided between the light receiving optical system 234 and the light receiving unit 232.

The measurement device 210 further includes the TOF measurement device 40, the controller 42, and the communication interface (I/F) 50. The information generated by the controller 42 is provided (transmitted) to the various utilizing devices 60 via the communication I/F 50.

### D-2. Specific Passband of Filter 233:

The specification sheet of the semiconductor laser 223 shows a specified wavelength band B. The specified wavelength band B is a variation range (a bandwidth) assumed in advance for the wavelength of the laser light (the emission light L1) emitted by the semiconductor laser 223. The specified wavelength band B is specified based on, for example, manufacturing variations of the semiconductor laser 223.

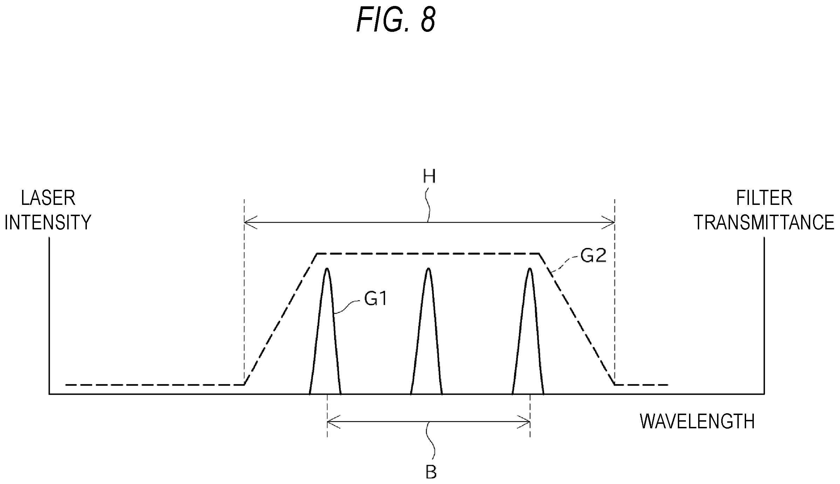

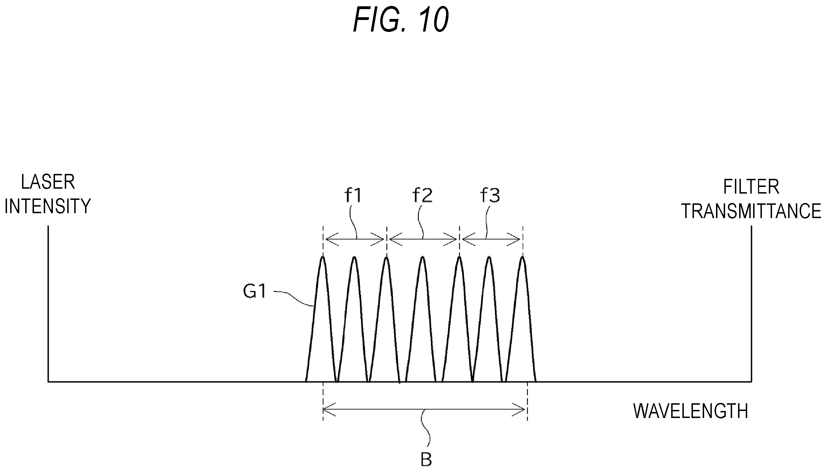

FIG. 8 is a diagram illustrating the specified wavelength band B of the semiconductor laser 223. In FIG. 8, the horizontal axis represents the wavelength band of light, the left vertical axis represents the laser intensity of the laser light (the emission light L1) emitted by the semiconductor laser 223, and the right vertical axis represents the filter transmittance of the filter 233 (the same applies to FIGS. 10 to 12 to be described later). A graph G1 in FIG. 8 is a result of measuring the laser intensity of the laser light for the plurality of semiconductor lasers 223 (the same applies to FIGS. 10 to 12 to be described later). According to the graph G1, the plurality of semiconductor lasers 223 have different peak wavelengths at which the laser intensity has a peak. That is, the wavelength (the peak wavelength) of the laser light varies among the plurality of semiconductor lasers 223. The specified wavelength band B is a band including a variation range of peak wavelengths assumed in advance for the semiconductor lasers 223.

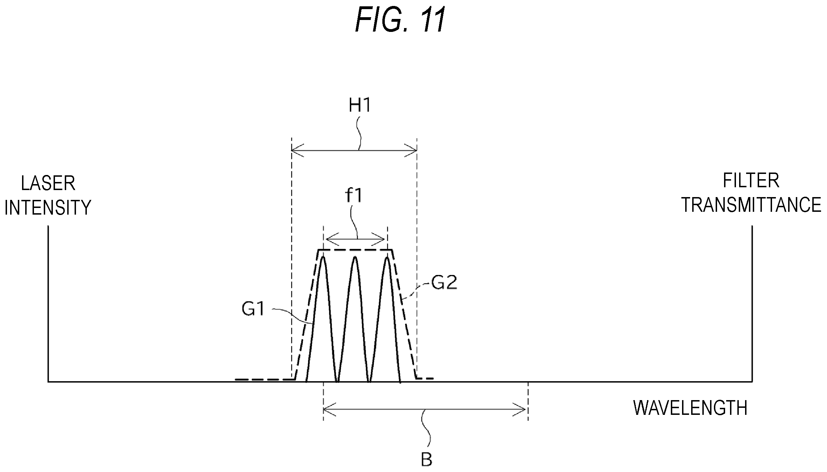

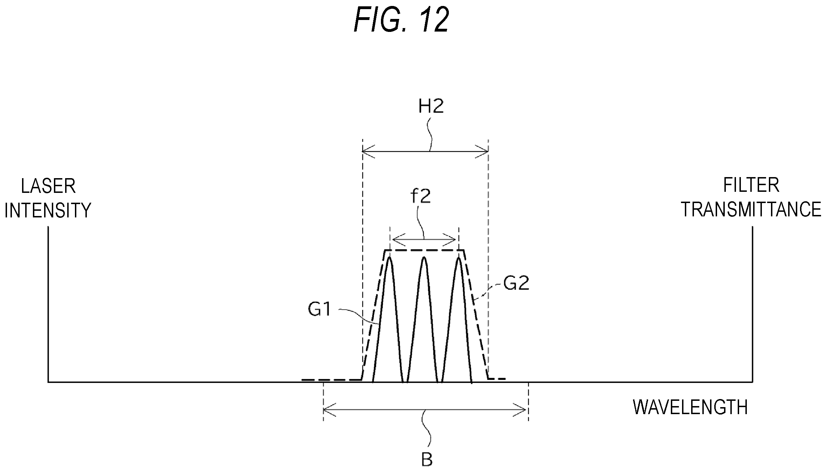

A graph G2 in FIG. 8 illustrates the filter transmittance (the same applies to FIGS. 11 and 12 to be described later). A reference sign H in FIG. 8 denotes a passband H of the filter according to the comparative example. The passband H of the filter according to the comparative example is set to a bandwidth including the specified wavelength band B. Therefore, the laser light emitted by all the semiconductor lasers 223 whose peak wavelengths belong to the specified wavelength band B passes through the filter according to the comparative example and is received by the light receiving unit 232. However, the passband H of the filter according to the comparative example is set to a wide bandwidth including the specified wavelength band B. Therefore, not only the laser light emitted by the semiconductor laser 223 but also ambient light such as sunlight having a wavelength different from that of the semiconductor laser 223 passes through the filter according to the comparative example and is received by the light receiving unit 232. As a result, the measurement accuracy (for example, the measurable distance is shortened) of the measurement device 210 may decrease.

On the other hand, in the measurement device 210 according to the present embodiment, the specific passband of the filter 233 is a part of the specified wavelength band B. The specific passband of the filter 233 includes a peak wavelength of laser light emitted by the semiconductor laser 223 mounted on the measurement device 210. The bandwidth of the specific passband of the filter 233 is equal to or less than 1/2 of the bandwidth of the specified wavelength band B.

### D-3. Method for Manufacturing Measurement Device 210:

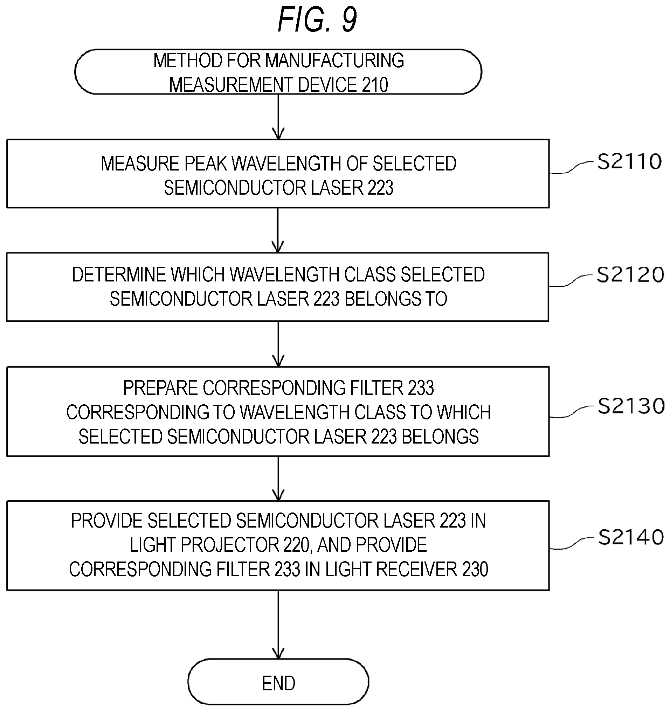

FIG. 9 is a flowchart illustrating a part of a manufacturing step of the measurement device 210, and FIG. 10 is a diagram illustrating classification of the specified wavelength band B. As illustrated in FIG. 10, the specified wavelength band B is divided into three wavelength classes f1 to f3. The three wavelength classes f1 to f3 are, for example, wavelength bands obtained by equally dividing the specified wavelength band B into three.

As illustrated in FIG. 9, the peak wavelength of a semiconductor laser 223 (hereinafter, sometimes referred to as a "selected semiconductor laser 223") selected from the plurality of semiconductor lasers 223 is measured (S2110). For example, the selected semiconductor laser 223 emits light, and the peak wavelength of the laser light emitted by the selected semiconductor laser 223 is measured by a known wavelength measurement device (such as a light wavelength meter).

Next, it is determined which wavelength class the peak wavelength of the selected semiconductor laser 223 belongs to (S2120). Based on the measurement result in S2110, it is determined which of the three wavelength classes f1 to f3 the selected semiconductor laser 223 belongs to. At least a part of the steps of S2110 and S2120 may be manually performed by a person or may be automatically performed by a machine such as a robot.

Next, the filter 233 (hereinafter also referred to as "corresponding filter 233") having a specific passband corresponding to the wavelength class to which the selected semiconductor laser 223 belongs is prepared (S2130). FIG. 11 is a diagram illustrating the specific passband H1 for the first wavelength class f1, and FIG. 12 is a diagram illustrating the specific passband H2 for the second wavelength class f2. As illustrated in FIG. 11, when the peak wavelength of the selected semiconductor laser 223 belongs to the first wavelength class f1, the specific passband H1 of the filter 233 has a bandwidth smaller than that of the specified wavelength band B and is a band that includes the first wavelength class f1. As illustrated in FIG. 12, when the peak wavelength of the selected semiconductor laser 223 belongs to the second wavelength class f2, the specific passband H2 of the filter 233 has a bandwidth narrower than that of the specified wavelength band B and is a band that includes the second wavelength class f2.

Next, the selected semiconductor laser 223 is provided in the light projector 220, and the corresponding filter 233 is provided in the light receiver 230 (S2140). Thereafter, the remaining assembly step and the like are performed, and the manufacturing of the measurement device 210 is completed. According to such a manufacturing method, the measurement device 210 in which the influence of noise is more effectively reduced can be efficiently manufactured.

### D-4. Advantageous Effects of Present Embodiment:

As described above, in the measurement device 210 according to the present embodiment, the specific passband of the filter 233 is a part of the specified wavelength band B. The specific passband of the filter 233 includes a peak wavelength of laser light emitted by the semiconductor laser 223 mounted on the measurement device 210. Therefore, according to the present embodiment, as compared with a configuration in which the specific passband of the filter 233 is the same as the specified wavelength band B, the influence of noise such as sunlight is reduced, and the measurable distance can be improved.

In the present embodiment, the bandwidth of the specific passband of the filter 233 is 1/2 or less of the bandwidth of the specified wavelength band B. Accordingly, it is possible to more effectively reduce the influence of noise.

### E. Modifications:

The technology disclosed in the present description is not limited to the embodiments described above, and can be modified into various forms without departing from the gist thereof, and for example, the following modifications are also possible.

The configurations of the measurement device 210, the light projector 220, and the light receiver 230 in the embodiment described above are merely examples and can be variously modified. For example, in the embodiment described above, the filter 233 is provided between the light receiving optical system 234 and the light receiving unit 232. Alternatively, the filter 233 may be provided in front of the light receiving optical system 234 or may be incorporated as a component of the light receiving optical system 234.

In the embodiment described above, the measurement device 210 includes one semiconductor laser 223 and one filter 233, but is not limited thereto, and may include a plurality of semiconductor lasers and a plurality of filters each corresponding to a respective one of the plurality of semiconductor lasers. For example, the light projector 220 may include a first semiconductor laser and a second semiconductor laser, and the light projector 220 may include a first filter that transmits the laser light emitted by the first semiconductor laser and a second filter that transmits the laser light emitted by the second semiconductor laser. In this case, it is preferable that the first semiconductor laser and the second semiconductor laser have the same specified wavelength band, and the first filter and the second filter have different specific passbands. Specifically, when the peak wavelength of the first semiconductor laser belongs to the first wavelength class f1 described above, the specific passband of the first filter is the specific passband H1 corresponding to the first wavelength class f1. When the peak wavelength of the second semiconductor laser belongs to the second wavelength class f2 described above, the specific passband of the first filter is the specific passband H2 corresponding to the first wavelength class f2. Accordingly, in the measurement based on the laser light of each of the first semiconductor laser and the second semiconductor, the influence of noise is reduced, and for example, the measurable distance can be improved.

In the embodiment described above, the bandwidth of the specific passband of the filter 233 is 1/2 or less of the bandwidth of the specified wavelength band B, but is not limited thereto, and may be, for example, 1/3 or less of the bandwidth of the specified wavelength band B and 1/5 or less of the bandwidth of the specified wavelength band B. The lower limit of the bandwidth of the specific passband of the filter 233 is not particularly limited, and may be, for example, 1/100 or more of the bandwidth of the specified wavelength band B, or may be 1/20 or more.

In the method for manufacturing the measurement device 210 in the embodiment described above, the specified wavelength band B is equally divided into three and divided into the three wavelength classes f1 to f3, but the present disclosure is not limited thereto, and the specified wavelength band B may be divided into two wavelength classes or four or more wavelength classes. At least two classes of the plurality of wavelength classes may have different bandwidths.

In the embodiments described above, the formation material of the members is merely an example, and the members may be formed of another material.

The plurality of embodiments disclosed in the present description can be appropriately combined, and configurations obtained by the combination are also included in the present disclosure. For example, the light source 122 in the first embodiment or the light source 122a in the second embodiment may be used as the light source 222 in the measurement device 210 in the third embodiment.

The present application is based on Japanese Patent Application No. 2023-116439 filed on July 18, 2023 and Japanese Patent Application No. 2023-116441 filed on July 18, 2023, and the contents are incorporated herein by reference.

## Claims

1. A light source comprising:
a light emitting chip on which a surface light emitting element is provided, the light emitting chip including:
a first surface electrically connected to a cathode of the surface light emitting element; and
a second surface electrically connected to an anode of the surface light emitting element;
a substrate on which a first conductive pattern and a second conductive pattern are formed;
a bonding portion configured to bond the first surface of the light emitting chip and the first conductive pattern, the bonding portion being conductive;
a wire configured to electrically connect the second surface of the light emitting chip and the second conductive pattern, and
a protection portion that is provided on an outer peripheral side of the bonding portion and that covers at least a part of an outer peripheral surface of the bonding portion, the protection portion being non-conductive.

2. The light source according to claim 1,
wherein a connection portion to which the wire is electrically connected is provided on a peripheral edge portion of the second surface of the light emitting chip, and
wherein the protection portion covers an outer peripheral surface of the bonding portion on a connection portion side.

3. The light source according to claim 1,
wherein the protection portion covers an entire outer peripheral surface of the bonding portion.

4. The light source according to any one of claims 1 to 3,
wherein at least a part of an outer peripheral surface of the bonding portion is located inside an outer edge of the light emitting chip, as viewed in a direction orthogonal to the light emitting chip, and
wherein the protection portion includes a support portion sandwiched between the light emitting chip and the substrate.

5. The light source according to any one of claims 1 to 3,
wherein the protection portion is in contact with an outer peripheral surface of the bonding portion, and an area of an exposed surface of the protection portion is larger than a contact area between the protection portion and the bonding portion.

6. A measurement device comprising:
a light projector including the light source according to any one of claims 1 to 3; and
a light receiver configured to receive light output from the light projector and reflected by a measurement target.

7. A method for manufacturing a light source including a light emitting chip on which a surface light emitting element is provided, the light emitting chip including a first surface electrically connected to a cathode of the surface light emitting element and a second surface electrically connected to an anode of the surface light emitting element, and a substrate on which a first conductive pattern and a second conductive pattern are formed, the method comprising:
a step of applying:
a first bonding material between the first surface of the light emitting chip and the first conductive pattern of the substrate, the first bonding material being conductive; and
a second bonding material to at least a part of a periphery of the first bonding material, the second bonding material being non-conductive;
a step of electrically connecting the second surface of the light emitting chip and the second conductive pattern by a wire; and
a step of curing the first bonding material and the second bonding material to form a conductive bonding portion formed between the first surface of the light emitting chip and the substrate and to form a protection portion configured to cover at least a part of an outer peripheral surface of the bonding portion.

8. A light source including:
a light emitting chip on which a surface light emitting element is provided, the light emitting chip including:
a first surface electrically connected to a cathode of the surface light emitting element; and
a second surface electrically connected to an anode of the surface light emitting element;
a substrate on which a first conductive pattern and a second conductive pattern are formed;
a bonding portion configured to bond the first surface of the light emitting chip and the first conductive pattern, the bonding portion being conductive; and
a wire configured to electrically connect the second surface of the light emitting chip and the second conductive pattern,
wherein, as viewed in a first direction orthogonal to the light emitting chip, at least a part of an outer peripheral surface of the bonding portion is located inside an outer edge of the light emitting chip, and
wherein the connection portion between the wire and the second surface is located inside the outer peripheral surface of the bonding portion.

9. The light source according to claim 8,
wherein, as viewed in the first direction, a peripheral edge of a light emitting region of the light emitting chip is located inside the outer peripheral surface of the bonding portion, and
wherein an inclination angle θ formed by a virtual surface with respect to the first direction is 45 degrees or more, the virtual surface passing through a ridge line of the light emitting region and a ridge line of the outer peripheral surface of the bonding portion.

10. A measurement device comprising:
a light projector including a semiconductor laser configured to emit laser light; and
a light receiver including:
a filter configured to transmit laser light in a specific passband in the laser light output from the light projector and reflected by a measurement target; and
a light receiving element configured to receive the laser light that is passed through the filter,
wherein the specific passband of the filter is a part of a specified wavelength band specified based on a manufacturing variation of the semiconductor laser.

11. The measurement device according to claim 10,
wherein the semiconductor laser includes a first semiconductor laser and a second semiconductor laser,
wherein the filter includes:
a first filter configured to transmit laser light emitted from the first semiconductor laser; and
a second filter configured to transmit laser light emitted from the second semiconductor laser,
wherein the first semiconductor laser and the second semiconductor laser have the same specified wavelength band, and
wherein the first filter and the second filter have different specific passbands.

12. The measurement device according to claim 10 or 11,
wherein a bandwidth of the specific passband is 1/2 or less of a bandwidth of the specified wavelength band.

13. A method for manufacturing a measurement device including a light projector including a semiconductor laser configured to emit laser light, and a light receiver including a filter configured to transmit laser light in a specific passband in the laser light output from the light projector and reflected by a measurement target, and a light receiving element configured to receive the laser light that is passed through the filter, the method comprising:
a step of determining which of a plurality of wavelength classes a selected semiconductor laser selected from a plurality of semiconductor lasers belongs to, the plurality of wavelength classes being specified by dividing a specified wavelength band specified based on a manufacturing variation of the semiconductor laser; and
a step of providing, in the light receiver, the filter having a specific passband corresponding to a wavelength class to which the selected semiconductor laser belongs.
